# DEMANDE DE BREVET EUROPEEN

(11) **EP 3 040 727 A1**
(43) Date de publication de la demande: **06.07.2016**
(21) Numéro de dépôt: 14307203.1
(22) Date de dépôt: 29.12.2014
(51) Int. Cl.: G01R 23/20, H04B 17/00

(54) **Procédé de mesure et de localisation de l'intermodulation passive d'un dispositif en test**

(71) Demandeur: Alcatel- Lucent Shanghai Bell Co., Ltd, Shanghai 201206 (CN)
(72) Inventeur: Harel, Jean-Pierre, 22305 LANNION (FR)
(74) Mandataire: Wetzel, Emmanuelle

(57) **Abrégé**

Un procédé de mesure de l'intermodulation passive d'un dispositif en test comprend une mesure réalisée en mode transmission, un signal d'entrée comprenant au moins deux composantes de fréquences distinctes étant envoyé au dispositif en test par l'intermédiaire d'une sonde placée dans des conditions de champ proche. De préférence le procédé comprend les étapes suivantes :
- un dispositif en test et une sonde sont disposées face à face dans des conditions de champ proche,
- un signal d'entrée comprenant au moins deux composantes de fréquences distinctes est introduit dans la sonde,
- Le signal d'entrée est envoyé par la sonde au dispositif en test,
- le signal d'entrée transmis et les produits d'intermodulation générés par le dispositif en test sont recueillis à l'entrée du dispositif en test.

Le système pour la mise en oeuvre de ce procédé comprend un dispositif en test, une sonde apte à envoyer un signal d'entrée comprenant au moins deux composantes de fréquences distinctes en direction du dispositif en test, et un analyseur de spectre pour recueillir le signal d'entrée transmis et les signaux d'intermodulation générés par le dispositif en test en vue de leur mesure.

## Description

### DOMAINE

La présente invention se rapporte au domaine des intermodulations passives, et notamment l'identification et la localisation de l'origine de ces intermodulations.

### ARRIERE PLAN

Il va devenir de plus en plus important de mesurer les intermodulations passives PIM (pour «Passive Inter Modulations » en anglais). Les utilisateurs de téléphones mobiles modernes attendent que leurs appareils produisent des débits élevés et homogènes. Les réseaux de quatrième génération (4G) affichent des vitesses de traitement des données mobiles plus rapides, à 100 Mbits/s, et cette vitesse de transmission plus élevée va augmenter l'exigence vis-à-vis des réseaux en matière d'intermodulation passive PIM. Les bonnes performances des réseaux en matière de PIM et de mesure de PIM sont désormais impératives. Les mesures de l'intermodulation passive PIM se révèlent donc essentielles pour pouvoir détecter les problèmes de réseau.

L'intermodulation est un problème d'interférence multi-signaux : deux signaux au moins se superposent ou s'opposent pour former un nouveau signal, ce qui produit l'intermodulation. Les intermodulations sont donc des signaux indésirables produits lors du passage de signaux utiles à travers un équipement radioélectrique. Si cet équipement est actif (amplificateur, transposition de fréquences...), on parlera d'intermodulations actives. S'il est passif (antenne, guide d'ondes, joints...), ce seront des intermodulations passives PIM. Habituellement, pour les tests concernant des appareils aériens, la mesure de PIM s'effectue alors soit dans un mode standard en réflexion, soit dans un mode en transmission, et dans ce dernier cas on peut la réaliser soit dans des conditions d'un scénario de type «zone de transition» soit dans des conditions d'un scénario en champ lointain

La proximité des éléments rayonnants dans une antenne, et notamment une antenne de type « panneau », génère des PIM qui peuvent avoir des causes multiples dont l'origine est difficile à identifier et à localiser. Pour les antennes, la méthode la plus simple et la plus couramment utilisée est la mesure des niveaux de PIM de l'antenne en mode réflexion.

Pour réaliser ce test, deux générateurs produisent deux porteuses de fréquences F1 et F2 respectivement. Celle-ci sont combinées et injectées dans le dispositif en test DUT (pour « Device Under Test » en anglais). En mode réflexion, les produits de PIM sont recueillis via la même ligne de transmission qui a permis l'injection des porteuses de fréquences F1 et F2. La réponse imparfaite du dispositif testé DUT crée des non-linéarités, et donc des PIM sont créés. Les intermodulations d'ordre 3 dit « IM3 » sont les intermodulations créés par les fréquences « 2F1-F2 » et « 2F2-F1 ». Les intermodulations d'ordre 5 dit « IM5 » sont les intermodulations créés par les fréquences « 3F1-2F2 » et « 3F2-2F1 », etc... Seuls les intermodulations d'ordre impair génèrent des signaux proches des porteuses F1 et F2, et doivent donc être combattues.

Ces PIM causent une perturbation du rapport signal/bruit : leurs niveaux ne doivent donc pas franchir une certaine limite. Par exemple, la norme standard 3GPP recommande pour des systèmes GSM-900MHz, utilisant deux porteuses de fréquences F1 et F2 de 43 dBm (20 W), que les niveaux d'intermodulation d'ordre 3 ne dépassent pas -100 dBm, donc restent inférieurs à 143 dBc.

Le principal problème avec la méthode opérant en mode réflexion, c'est que l'opérateur du test de PIM a une information correcte sur le fait que le dispositif testé DUT remplit ou ne remplit pas les critères requis par la spécification relative aux PIM. Mais dans le cas où l'antenne testée ne remplit pas ces critères, il n'a aucune information sur l'origine des PIM et leur localisation.

Il existe des techniques de localisation des sources de PIM exploitants les vitesses de propagation des signaux (mesures par réflectométrie temporelle par exemple) ,mais, ces techniques ne s'appliquent actuellement que pour des appareils comprenant des circuits de faible complexité comme par exemple des câbles coaxiaux ou des guides d'ondes. Les antennes panneaux comprenant des circuits d'alimentation qui peuvent être complexes et de très nombreux composants, l'utilisation d'une telle technique de type temporel ne permet pas de localiser correctement la ou les sources de disfonctionnement.

Actuellement, la seule façon d'obtenir ces informations est d'engager une campagne de test complémentaire en créant des contraintes, telles que des perturbations thermiques ou mécaniques localisés, ou encore des vibrations, chocs, etc. Comme les PIM sont principalement créés à partir de mauvais contacts ou de connexions défectueuses, le fait de répartir dans le dispositif en test DUT ces contraintes permet d'imposer une contrainte excessive aux parties défectueuses, et donc de déterminer l'origine des PIM. Cette recherche de l'origine des PIM peut être longue et laborieuse, et elle exige des opérateurs formés.

Un autre problème est dû au fait que les phénomènes d'intermodulation observés en mode réflexion et en mode transmission peuvent être légèrement différents selon l'origine des PIM et leur localisation. Par conséquent, il peut être avantageux d'opérer une mesure de PIM dans les deux modes de mesure, en transmission et en réflexion.

En haute fréquence, la mesure de PIM en mode transmission pour des appareils aériens s'effectue dans des conditions de champ lointain, c'est-à-dire à des distances telles que la distance de champ lointain R vérifie la relation R ≥ 2D²/λ où λ est la longueur d'onde électromagnétique principale du signal émit par le DUT et D est la plus grande dimension du DUT, par exemple sa hauteur dans le cas d'une antenne panneau. Néanmoins, les conditions de champ lointain nécessaires pour la mesure de PIM en mode transmission présentent au moins deux inconvénients.

D'une part, la distance nécessaire entre le dispositif testé DUT et l'emplacement de la sonde peut être très importante. Par exemple pour une antenne basse fréquence à 900 MHz longue de 2,60 mètres, les conditions de champ lointain sont obtenues à partir d'une distance de 40 mètres ; par conséquent, soit la chambre anéchoïque de test est extrêmement longue si les tests sont effectués à l'intérieur d'un bâtiment, soit cette mesure doit être réalisée à l'extérieur ;

D'autre part, pour un seuil de PIM de -100 dBm par exemple, en considérant le cas d'une bande de basse fréquence à 900 MHz et avec des conditions de champ lointain à partir de 40 mètres, la perte en espace libre supplémentaire est d'au minimum 64 dB. Les gains des antennes utilisées dans le test en configuration de champ lointain sont également à prendre en considération, mais il ne fait aucun doute que le signal reçu à l'emplacement de la sonde est très faible et que les mesures de PIM sont donc très médiocres en dynamique et en précision.

Les champs électromagnétiques entourant une antenne de grande taille peuvent être découpés en quatre régions principales représentant chacune une zone de l'espace. Une première région du champ proche dite zone réactive (appelée aussi zone évanescente) est l'espace à proximité immédiate de l'antenne où prédominent les éléments réactifs (énergie emmagasinée) et où l'énergie est emmagasinée dans le champ. Une deuxième région du champ proche dite zone de rayonnement (appelée aussi zone de Fresnel). Dans cette zone de rayonnement, qui commence à la distance de l'antenne où le champ réactif a diminué pour se réduire à presque rien, le gain d'antenne et la distribution angulaire du champ rayonnant varient proportionnellement à la distance de l'antenne. Ceci est dû au fait que les relations de phase et d'amplitude des ondes arrivant depuis les différentes zones de l'antenne au point d'observation changent selon la distance. Pour les antennes électriquement *grandes* (D < λ), cette région s'étend de R = λ/2π à R = ½D²/λ. Une troisième région dite zone de transition (appelée aussi zone du champ intermédiaire). Cette zone de transition présente une combinaison de caractéristiques de la région du champ proche et de la région du champ lointain, mais les caractéristiques du champ lointain sont de plus en plus prédominantes à mesure qu'on s'éloigne de l'antenne. La zone de transition s'étend de ½D²/λ à 2D²/λ. On considère que c'est dans cette zone que commencent les conditions de champ lointain. Enfin, une quatrième région dite zone de champ lointain (appelée aussi zone de Fraunhofer). La zone de champ lointain est suffisamment éloignée de la source du rayonnement pour que les relations de phase et d'amplitude des ondes arrivant de diverses parties de l'antenne ne changent pas de façon appréciable avec la distance. Le gain d'antenne et la configuration angulaire sont indépendants de la distance, et la densité de puissance est inversement proportionnelle au carré de la distance de la source de rayonnement. Bien que le passage d'une région à l'autre à partir de la première région de champ proche sans rayonnement se fasse de façon graduelle, lors de la conception et l'ingénierie des antennes, on estime généralement que la quatrième région dite zone de champ lointain commence à une distance d'environ R = 2D²/λ pour les antennes de grande puissance, et que la zone de champ lointain s'étend à l'infini (« D » étant la plus grande dimension d'ouverture linéaire et λ la longueur d'onde à la fréquence d'intérêt). Les champs E et H sont orthogonaux et Z=E/H=377 ohms. Cette quatrième région s'étend de 2D²/λ à l'infini.

Afin de surmonter les questions de la dimension de mise en oeuvre du test et du faible niveau du signal détecté en champ lointain, il apparaît avantageux d'effectuer la mesure de PIM en mode transmission dans un scénario de type «zone de transition», c'est à dire à une distance comprise entre λ et 2D²/λ où D est la plus grande dimension du DUT. Dans ce cas, la distance du dispositif en test DUT à la sonde est généralement réduite de quelques mètres par rapport aux conditions de champ lointain, et donc le niveau du signal mesuré augmente.

Dans le cas où la mesure n'est pas réalisée dans des conditions d'onde plane (i.e. conditions de Fraunhofer en champ lointain), si la distance du dispositif en test DUT à la sonde et le gain de la sonde sont correctement fixés (par exemple quelques mètres et quelques dBi), une campagne d'étalonnage complémentaire est nécessaire pour permettre d'évaluer les niveaux de rayonnement de PIM, c'est-à-dire d'établir une relation pertinente entre les niveaux de PIM mesurés dans le mode standard en réflexion (i.e. à travers le câble d'entrée) et cette zone de transition rayonnante. Il convient de noter que, les conditions d'onde plane n'étant ici pas atteintes, le résultat de la campagne d'étalonnage ne sera valide que pour un test type et pour un dispositif testé d'un type donné. En effet, en dehors de la mesure effectuée en champ lointain (onde plane), la relation entre les niveaux de rayonnement et de conduction de PIM est fluctuante en fonction du réglage du test et du dispositif testé DUT.

Un tel test réalisé en dehors des conditions de champ lointain permet d'apprécier le comportement en PIM du dispositif antennaire testé DUT à la fois en mode réflexion et en mode transmission dans un scénario intérieur ne nécessitant pas de chambre anéchoïque de dimension excessive.

Le mode de mesure en transmission seul dans des conditions hors champ lointain est particulièrement intéressant pour les antennes actives, qui sont des antennes comprenant des composants actifs comme par exemple l'intégralité des circuits de RRH (pour « Remote Radio Head » en anglais). Pour ces antennes actives, seul un test de PIM en mode transmission est réalisable car les signaux de fréquences F1 et F2 sont générés à l'intérieur même de l'antenne, et donc une mesure en mode réflexion n'est pas concevable.

Malgré tous ces efforts et si le résultat du test de PIM n'est pas conforme, cette méthode n'indique toujours pas néanmoins quels sont les points faibles à l'origine de PIM et où ils se situent. Et la difficile mesure pour déterminer l'origine des PIM, précédemment décrite, doit donc être menée en cas d'échec du test.

### RESUME

Comme on vient de le voir, on ne connait actuellement aucune méthode permettant de déterminer les niveaux de PIM d'une antenne et en même temps, en cas d'échec du test, de localiser l'origine des PIM. Il est donc proposé une méthode permettant de résoudre ce problème en modifiant le procédé de test connu.

L'objet de la présente invention est un procédé de mesure de l'intermodulation passive d'un dispositif en test. La mesure est réalisée en mode transmission, un signal d'entrée comprenant au moins deux composantes de fréquences distinctes étant envoyé au dispositif en test par l'intermédiaire d'une sonde placée dans des conditions de champ proche.

La solution proposée consiste à inverser le schéma de mesure de PIM c'est-à-dire de ne pas injecter de porteuses de fréquences F1 et F2 dans le connecteur du port d'entrée du dispositif en test DUT comme dans les méthodes connues, mais au contraire d'introduire un signal d'entrée comprenant au moins deux composantes de fréquences distinctes F1 et F2 via une sonde placée dans des conditions de champ proche afin d'effectuer une mesure en mode transmission. On entend ici par « champ proche » les première, deuxième et troisième régions correspondant à la zone réactive, la zone de rayonnement et la zone de transition.

Selon un mode de réalisation, le procédé comprend les étapes suivantes :
- un dispositif en test et une sonde sont disposés face à face dans des conditions de champ proche,
- un signal d'entrée comprenant au moins deux composantes de fréquences distinctes est introduit dans la sonde,
- le signal d'entrée est envoyé par la sonde au dispositif en test,
- le signal d'entrée transmis et les produits d'intermodulation générés par le dispositif en test sont recueillis à l'entrée du dispositif en test.

Selon un aspect, la distance entre le dispositif en test et la sonde est inférieure à 2D²/λ où λ est la longueur d'onde électromagnétique du signal principal émis par le dispositif en test et D est la plus grande dimension du dispositif en test..

Selon un autre aspect, le signal d'entrée transmis et les produits d'intermodulation générés par le dispositif en test, qui sont recueillis à l'entrée du dispositif en test, sont envoyés à un analyseur de spectre à partir duquel les mesures sont effectuées.

L'invention a aussi pour objet un système pour la mise en oeuvre de ce procédé qui comprend :
- un dispositif en test,
- une sonde apte à envoyer un signal d'entrée comprenant au moins deux composantes de fréquences distinctes en direction du dispositif en test,
- un analyseur de spectre pour recueillir le signal d'entrée transmis et les signaux d'intermodulation générés par le dispositif en test en vue de leur mesure.

Selon un mode de réalisation, la sonde est placée à une distance du dispositif en test telle que le faisceau du signal d'entrée comprenant au moins deux composantes de fréquences distinctes recouvre en totalité le dispositif en test.

Selon un autre mode de réalisation, la sonde est apte à se déplacer le long du dispositif en test afin que le signal d'entrée comprenant au moins deux composantes de fréquences distinctes balaye la totalité du dispositif en test.

Selon un aspect, la sonde est placée face au dispositif en test dans des conditions de champ proche.

Selon un autre aspect, la sonde est placée à une distance du dispositif en test qui est inférieure à 2D²/λ où λ est la longueur d'onde électromagnétique du signal principal émis par le dispositif en test et D est la plus grande dimension du dispositif en test.

### BREVE DESCRIPTION

D'autres caractéristiques et avantages apparaîtront à la lecture de la description qui suit d'un mode de réalisation, donné bien entendu à titre illustratif et non limitatif, et dans le dessin annexé sur lequel
- la figure 1 illustre schématiquement le principe de la mesure de PIM d'une antenne en mode réflexion et en mode transmission,
- la figure 2 illustre schématiquement un mode de réalisation de la mesure de PIM d'une antenne,
- les figures 3a, 3b et 3c illustrent des exemples de scénario de test de la mesure de PIM pour une antenne,
- la figure 4 illustre un autre mode de réalisation de la mesure de PIM d'une antenne,
- la figure 5 illustre un mode de réalisation de la recherche des causes de disfonctionnement.

### DESCRIPTION DETAILLEE

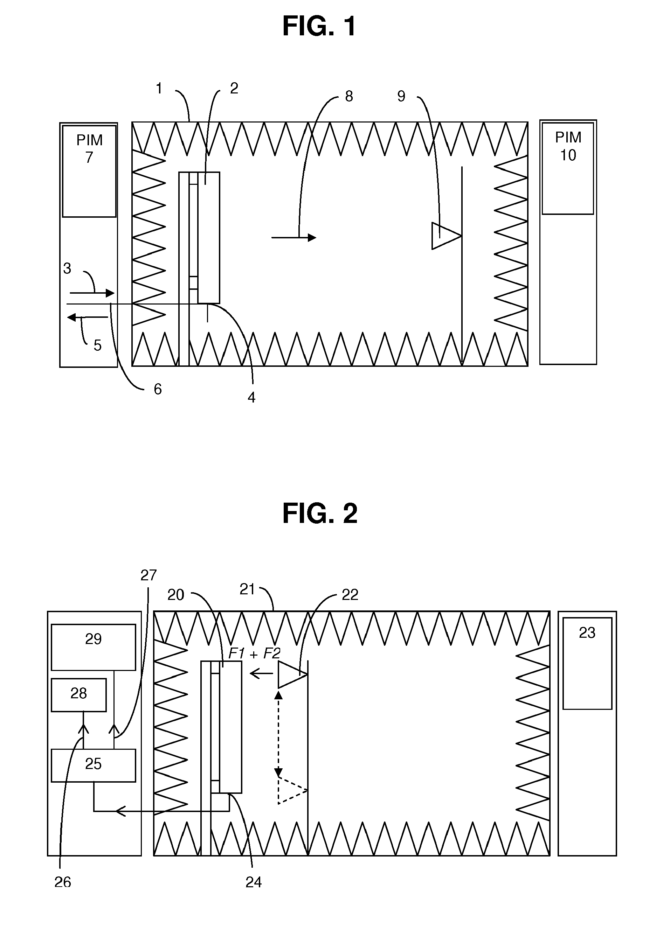

Le principe de la mesure de PIM d'un dispositif à tester DUT en mode réflexion et en mode transmission, dans le cas d'une antenne directive, est illustré sur la figure 1. La conduite d'une mesure du niveau de PIM peut se révéler délicate à cause de sa sensibilité à l'équipement de test et à l'environnement.

Le test de PIM en réflexion est le type de test le plus couramment utilisé. Ce test comporte l'injection de deux porteuses de fréquences F1 et F2 dans un port situé à l'entrée d'un dispositif à tester DUT et l'utilisation de ce même port pour capturer et mesurer les PIM. Dans une chambre anéchoïque **1,** on place un dispositif à tester DUT **2,** ici une antenne panneau. Les deux porteuses de fréquences F1 et F2 sont alors injectées en direction **3** du port d'entrée 4 du dispositif en test DUT **2.** Etant donné que le dispositif en test DUT **2** ne dispose ici que d'un seul port d'entrée **4** accessible (c'est-dire qu'aucun connecteur n'est disponible comme port de sortie), les PIM créés par le dispositif en test DUT **2** sont collectés en direction inverse **5** via la même ligne de transmission **6** déjà utilisée pour l'injection des porteuses de fréquences F1 et F2. L'amplitude des PIM est détectée en mode réflexion par un détecteur **7.**

Un test de PIM en transmission est réalisé en utilisant une sonde mesurant les signaux transmis dans les conditions de champ lointain, comme par exemple dans une chambre anéchoïque de grande dimension. Les PIM créés par le dispositif en test DUT **2** sont transmis en direction 8 d'une sonde **9.** L'amplitude des PIM est alors détectée en mode transmission par un analyseur de spectre **10** à partir duquel on va effectuer les mesures.

Dans le mode de réalisation illustré sur la figure 2, un dispositif en test DUT **20** est placé dans une chambre anéchoïque **21.** Une sonde **22** est disposée à très courte distance (quelques millimètres ou quelques centimètres) du dispositif en test DUT **20** dans une situation de champ proche. Dans le cas où le DUT **20** est une antenne de type panneau, la sonde **22** est apte à se déplacer linéairement selon un trajet parallèle au DUT **20.**

Un signal, dit signal d'entrée, comprenant au moins deux composantes de fréquences distinctes F1 et F2 issus d'un générateur **23** est injecté dans la sonde **32** afin d'être envoyés en direction du DUT **20** via la sonde **22** pour une mesure en mode transmission dans un scénario de champ proche. Ainsi le sens de circulation du signal d'entrées porteur des fréquences F1 et F2 est inversé par rapport à la figure 1. La sonde **22** se déplace le long du DUT **20** afin que le signal de fréquences combinées F1 et F2 balayent la totalité du DUT **20.** Le signal porteur des fréquences F1 et F2 transmis et les PIM produits par le DUT **20** sont recueillis à la sortie **24** du DUT **20** dans un duplexeur **25.** Le duplexeur **25** sépare les bandes de fréquences correspondant au signal de fréquences combinées F1 et F2 transmis **26** d'une part des PIM 27 d'autre part. La bande de fréquences correspondant au signal porteur des fréquences F1 et F2 transmis **26** est envoyée vers une charge **28.** Alors que la bande de fréquences correspondant à la génération de PIM **27** est dirigée vers un analyseur de spectre **29** à partir duquel les mesures seront effectuées.

En balayant le dispositif en test DUT **20,** le signal d'entrée génère des PIM de niveaux différents selon la zone touchée par ces signaux au cours du balayage, ce qui est mis en évidence par l'analyseur de spectre **29.** Par conséquent, lorsqu'une zone touchée par le signal d'entrée contenant les fréquences F1 et F2 est une zone de génération de PIM, le niveau de PIM mesuré à cet instant sera plus élevé que dans d'autres zones ne générant pas de PIM.

On remarque que dans les principes de mesure illustrés sur la figure 1, la sonde doit être suffisamment directive pour permettre d'accéder à la dynamique et la précision requises lors de la mesure, et elle doit aussi être proche du dispositif en test DUT. Mais des conditions de mesure de PIM favorables exigent que la sonde ait une dimension réduite. Sa taille doit donc être aussi réduite que possible car une sonde de grande taille placée en face d'un dispositif en test DUT créerait une inadaptation et des perturbations en champ proche, et de ce fait augmenterait considérablement le risque de génération de PIM. Toutefois utiliser une sonde de taille trop réduite signifierait une faible directivité et un faible gain ce qui peut être défavorable à la dynamique de la mesure et donc la performance de cette méthode.

Dans le procédé illustré sur la figure 2, les inconvénients des procédés connus sont contournés et/ou sensiblement réduits. En considérant par exemple que le gain, et donc la taille de la sonde, n'est pas nécessaire grand et que cette limitation du gain peut être surmontée par un ajustement de l'amplitude du signal d'entrée comprenant au moins deux composantes de fréquences distinctes F1 et F2.

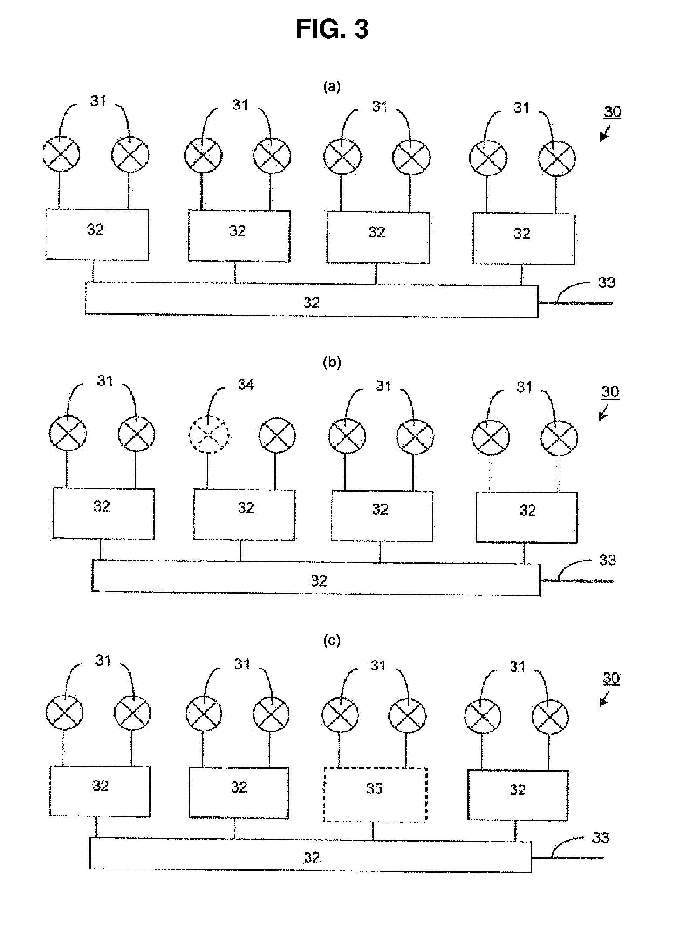

Les figures 3a à 3c illustrent des exemples de scénario de test de la mesure de PIM pour une antenne de station de base de type panneau. Schématiquement une antenne panneau **30** simplifiée comprend les composants principaux suivants : plusieurs éléments rayonnants **31,** un réseau d'alimentation comportant des répartiteurs de puissance **32** et un câble d'entrée principal **33.** Dans le cas présent, tous les éléments rayonnants sont alimentés avec le même niveau d'amplitude par rapport au connecteur du câble d'entrée principal **33.** Cependant, ce n'est pas forcément le cas en pratique, et il sera donc nécessaire soit de faire varier la puissance d'émission de la sonde en fonction de sa localisation vis-à-vis de l'antenne, soit de garder constant le niveau de la puissance d'émission de la sonde mais de corriger la réponse apportée par l'analyseur de spectre.

Dans le cas de la figure 3a, aucun des composants principaux de l'antenne en test **30** ne génèrent de PIM. La figure 3b illustre le cas où le composant défectueux **34** est l'un des éléments rayonnants **31.** La figure 3c illustre le cas où un répartiteur de puissance **32** est le composant défectueux **35.**

Dans le cas où l'antenne en test DUT **30** génère des PIM dont l'origine peut être un élément rayonnant **31** (cas de la figure 3b) ou un répartiteur de puissance **32** (cas de la figure 3c), etc..., le niveau de PIM sera au maximum lorsque la sonde sera placée au droit du composant défectueux **34, 35** dans le chemin direct du signal porteur des fréquences F1 et F2.

Au contraire, si l'origine des PIM est située dans un composant commun, comme par exemple le câble d'entrée principal **33,** quel que soit l'élément rayonnant **31** balayé, le niveau de PIM mesuré sur le dispositif en test DUT **30** sera identique.

Par conséquent cette solution permet une détermination de la localisation de l'origine des PIM selon le type d'antenne et sa disposition telle que l'amplitude et la phase des éléments rayonnants, en surveillant les niveaux de PIM au cours du balayage par la sonde,

Pour la détermination du niveau de PIM d'une antenne, une campagne d'étalonnage préalable est nécessaire afin d'évaluer de manière cohérente les niveaux des signaux mesurés au droit du composant générateur de PIM, et de déterminer si ces niveaux sont normaux ou s'ils conduisent à outrepasser les recommandations de la norme 3GPP pour les niveaux de PIM pour l'ensemble du dispositif en test DUT.

Pour accélérer la mesure complète de PIM puis la localisation de l'origine des PIM un autre mode de réalisation de la mesure de PIM peut être proposé dans un même environnement de test.

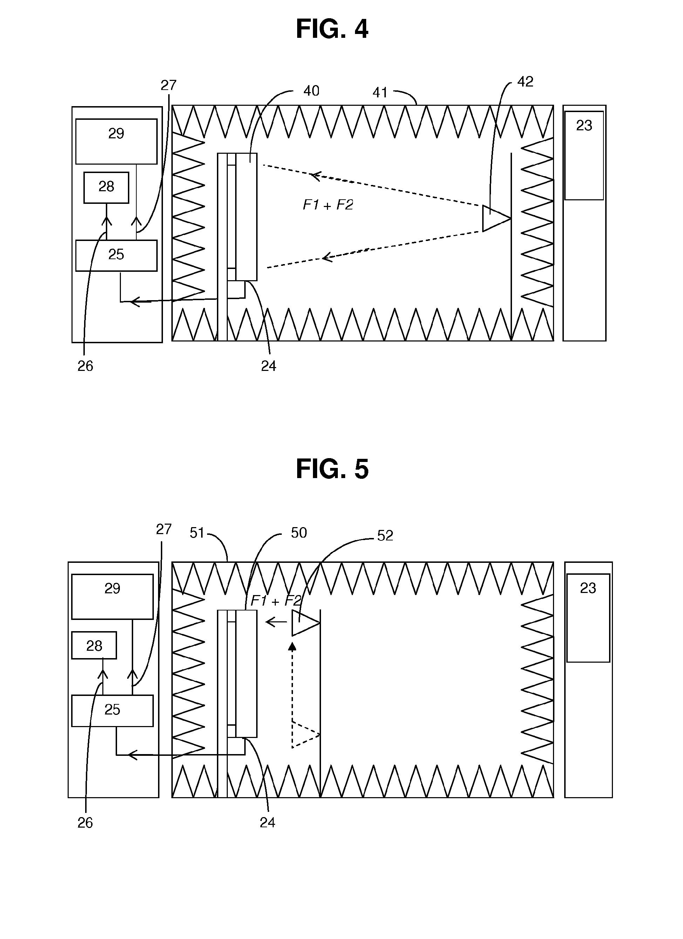

On considérera maintenant la figure 4 qui illustre un mode de réalisation avantageux de la mesure de PIM. Un dispositif à tester DUT **40** est placé dans une chambre anéchoïque **41.** Une sonde **42** est disposée à une distance du dispositif en test DUT **40** telle que le faisceau du signal comprenant au moins deux composantes de fréquences F1 et F2 distinctes recouvre en totalité le dispositif en test DUT **40.** De préférence la sonde **52** est placée dans la zone de transition en réalisant une campagne de calibration préalable afin de limiter les erreurs de mesures inhérentes à cette mesure effectuée en dehors des conditions d'ondes planes (champ lointain)..Ainsi les PIM sont mesurés sur l'ensemble du dispositif en test DUT **40.**

Dans le cas où le résultat du test de PIM ne serait pas satisfaisant, une recherche de localisation des disfonctionnements peut être effectuée comme illustré sur la figure 5. Un dispositif à tester DUT **50** est placée dans une chambre anéchoïque **51.** De préférence la sonde **52** est alors placée à une distance très proche du dispositif à tester DUT **50,** c'est-à-dire dans des conditions de champ proche correspondant à la zone réactive et la zone de rayonnement, et l'amplitude du signal porteur des fréquences F1 et F2 est modifiée si nécessaire afin de mettre en évidence la localisation de l'origine des PIM. De la même façon que dans le mode de réalisation de la figure 2, un signal d'entrée, comprenant au moins deux composantes de fréquences distinctes F1 et F2 est envoyé au dispositif à tester DUT **50** via la sonde **52** qui se déplace selon un trajet parallèle au dispositif à tester DUT **50.**

## Revendications

1. Procédé de mesure de l'intermodulation passive d'un dispositif en test, **caractérisé en ce que** la mesure est réalisée en mode transmission, un signal d'entrée comprenant au moins deux composantes de fréquences distinctes étant envoyé au dispositif en test par l'intermédiaire d'une sonde placée dans des conditions de champ proche.

2. Procédé selon la revendication 1, dans lequel
- un dispositif en test et une sonde sont disposées face à face dans des conditions de champ proche,
- un signal d'entrée comprenant au moins deux composantes de fréquences distinctes est introduit dans la sonde,
- Le signal d'entrée est envoyé par la sonde au dispositif en test,
- le signal d'entrée transmis et les produits d'intermodulation générés par le dispositif en test sont recueillis à l'entrée du dispositif en test.

3. Procédé selon l'une des revendications 1 et 2, dans lequel la distance entre le dispositif en test et la sonde est inférieure à 2D²/λ où λ est la longueur d'onde électromagnétique du signal principal émis par le dispositif en test et D est la plus grande dimension du dispositif en test.

4. Procédé selon l'une des revendications 1 à 3, dans lequel le signal d'entrée transmis et les produits d'intermodulation générés par le dispositif en test, qui sont recueillis à l'entrée du dispositif en test, sont envoyés à un analyseur de spectre à partir duquel les mesures sont effectuées.

5. Système pour la mise en oeuvre du procédé selon l'une des revendications précédentes, comprenant
- un dispositif en test,
- une sonde apte à envoyer un signal d'entrée comprenant au moins deux composantes de fréquences distinctes en direction du dispositif en test,
- un analyseur de spectre pour recueillir le signal d'entrée transmis et les signaux d'intermodulation générés par le dispositif en test en vue de leur mesure.

6. Système selon la revendication 5, dans lequel la sonde est placée à une distance du dispositif en test telle que le faisceau du signal d'entrée comprenant au moins deux composantes de fréquences distinctes recouvre en totalité le dispositif en test.

7. Système selon la revendication 5, dans lequel la sonde est apte à se déplacer le long du dispositif en test afin que le signal d'entrée comprenant au moins deux composantes de fréquences distinctes balaye la totalité du dispositif en test.

8. Système selon l'une des revendications 5 à 7, dans lequel la sonde est placée face au dispositif en test dans des conditions de champ proche.

9. Système selon la revendication 8, dans lequel la sonde est placée à une distance du dispositif en test qui est inférieure à 2D²/λ où λ est la longueur d'onde électromagnétique du signal principal émis par le dispositif en test et D est la plus grande dimension du dispositif en test.
